# EUROPEAN PATENT APPLICATION

(11) **EP 0 762 637 A2**
(43) Date of publication of application: **12.03.1997**
(21) Application number: 96306236.9
(22) Date of filing: 28.08.1996
(51) Int. Cl.: H03G 3/30

(54) **Variable output amplifier**

(30) Priority: 28.08.1995 JP 219232/95
(71) Applicant: NEC CORPORATION, Tokyo (JP)
(72) Inventor: Tsumura, Soichi, Tokyo (JP)
(74) Representative: Orchard, Oliver John

(57) **Abstract**

In a variable output amplifier apparatus, an input signal (S_{IN}) is distributed by a distributing unit (1) as first signals (S₁, S₂, ..., Sₙ) to a plurality of variable gain units (2-1, 2-2, ..., 2-n) having different gains. Second signals (S₁', S₂', ..., Sₙ') generated from the variable gain units are combined by a combining unit (3) to generate an output signal (S_{OUT}). A plurality of power supply control units (4-1, 4-2, ..., 4-n) apply power supplies (V_{CC1}, V_{CC2}, ..., V_{CCn}) to the variable gain units, respectively. The variable gain units and the power supply control units are controlled by a control unit. When one of the variable gain units and one of the power supply control units are activated, the corresponding power supply is turned ON. When they are deactivated, the corresponding power supply is turned OFF.

## Description

The present invention relates to a variable output amplifier apparatus which may, for example, be used in a mobile communications transmitter in which, severe restrictions are imposed on power dissipation.

In general, there is a deterioration in communication by mobile communication apparatus compared with that by line or wire communication apparatus. In particular the level of received signals fluctuates greatly during communications by mobile apparatus. For example, in cellular telephones, the range of the intensity level can be between about 80 dB to 100 dB.

In a previously proposed mobile communication system known to the applicants, since it is difficult to superpose information on to the amplitude components of carriers, such information was superposed on to the frequency components of the carriers. This system is called a constant envelope modulation system. With this modulation system, it is possible to reproduce original information by carrying out nonlinear processing, such as saturation amplification, and also, it is possible to remove harmonic components due to the saturation amplification by using bandpass filters. Therefore, saturation amplification is carried out both at transmission and reception. As a result, in a receiving apparatus, the above-mentioned large fluctuation of received signal level is absorbed. On the other hand, in a transmitting apparatus, effective use is made of a power supply by employing the efficiency of the non-linear amplification.

Incidentally, as demands for mobile communications have been increasing, linear modulation systems and multi-valued transmission systems have been considered. In the linear modulation systems and the multi-valued transmission systems, however, if non-linear processing is carried out, the bandwidth occupied is made broad, and the information superposed on the amplitude of the carriers is destroyed. Thus, a wide range variable output amplifier apparatus is required at both the transmitter and the receiver in such systems.

On the other hand, in a direct sequence code division multiple access (DS-CDMA) system, in which a plurality of mobile stations use the same frequency band simultaneously, a base station has to receive signals from all of the mobile stations at approximately the same level. That is, if the intensity of a signal from one mobile station is too strong, it is difficult to exclude its effect upon the other mobile stations, which reduces the actual transmission capacity. Thus, a wide range variable output amplifier apparatus is also required at the transmitting side of such a system.

In a first previously proposed variable output amplifier apparatus for power transmission (see: JP-A-58-83437), an input signal is amplified by first and second power amplifiers. A part of an output signal from the second power amplifier is fed back by a directional coupler to a detector. The directional coupler also provides an output signal. A control circuit compares the output of the detector with a reference voltage, and as a result, the power supply of the first power amplifier is controlled in accordance with the result of the comparison of the output of the detector with the reference voltage. In addition, when the transmission power is low, a changeover switch is selected, so that the power supply of the second power amplifier is switched to the same power supply for the first power amplifier. This will be explained later in detail.

In this first previously proposed apparatus, however, when the changeover switch is switched, a large noise spike is generated in the transient state. Also, since the gains of the power amplifiers are controlled by their power supply, the input/output impedance conditions of the power amplifiers are changed. Further, the operation of the detector in a wide range between approximately 80 dB and 100 dB is very difficult.

In a second previously proposed variable output amplifier apparatus (see: JP-A-60-212013), a plurality of first amplifiers is connected in parallel for receiving an input signal. The first amplifiers are connected via a first changeover switch to a plurality of second amplifiers connected in parallel, the second amplifiers being connected via a second changeover switch to a detector. The second changeover switch provides an output signal. On the other hand, the output signal of the detector is supplied to a selection determination circuit for controlling the changeover switches. That is, the selection determination circuit selects an optimum combination of one of the first amplifiers and one of the second amplifiers in accordance with the output of the detector. This will also be explained later in detail.

Even in the second prior art apparatus, however, when the changeover switches are switched to control the gain, a large noise spike is generated during the transient state. Also, changing a signal path causes a change in the delay time, and thus, an interruption may occur in a continuous signal.

A feature of an arrangement to be described below and illustrative of the present invention is that a wide range variable output apparatus with a high efficiency is provided.

In a particular variable output amplifier apparatus to be described below illustrative of the present invention, an input signal is distributed by a distributing unit as first signals to a plurality of variable gain units having different gains and providing maximum output power. Second signals generated by the variable gain units are combined by a combining unit to generate an output signal. A plurality of power supply control units supplies power to each of the variable gain units, respectively. The variable gain units and the power supply control units are controlled by a control unit. When one of the variable gain units and one of the power supply control units are activated, the corresponding power supply is rapidly turned ON. When they are deactivated, the corresponding power supply is slowly turned OFF.

When the power supply is rapidly turned ON, the gain of the corresponding variable gain unit is still low, so that noise due to turning ON the power supply can be neglected. Also, when the power supply is slowly turned off, the gain of the corresponding variable gain unit is already low, so that noise due to turning OFF the power supply can be also neglected.

The following description and drawings disclose previously proposed arrangements and, by means of examples, the invention which is characterised in the appended claims, whose terms determine the extent of the protection conferred hereby.

In the drawings:-
Fig. 1 is a block schematic circuit diagram illustrating a first previously proposed variable output amplifier apparatus;
Fig. 2 is a block schematic circuit diagram illustrating a second previously proposed variable output amplifier apparatus;
Fig. 3 is a block schematic circuit diagram illustrating a first embodiment of a variable output amplifier illustrative of the present invention;
Fig. 4 is a diagram showing gains of the variable gain units of Fig. 3;
Figs. 5A through 5E are timing diagrams showing the operation of the apparatus of Fig. 3;
Fig. 6 is a block schematic circuit diagram illustrating a second embodiment of a variable output amplifier illustrative of the present invention;
Figs. 7A, 7B, 7C and 7D are timing diagrams showing the operation of the control unit of Fig. 6.
Fig. 8 is a detailed block schematic circuit diagram for each of the variable gain units of Fig. 3;
Fig. 9 is a block schematic circuit diagram illustrating a modification of the variable gain unit of Fig. 8; and
Fig. 10 is a detailed circuit diagram of the power supply control circuit of Fig. 3.

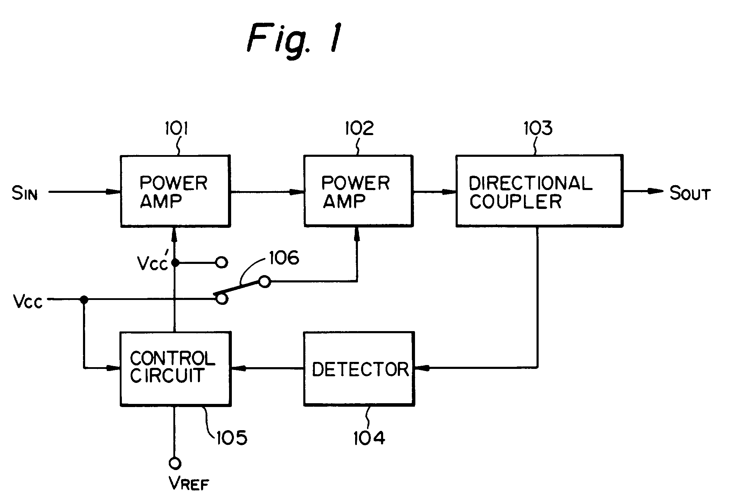

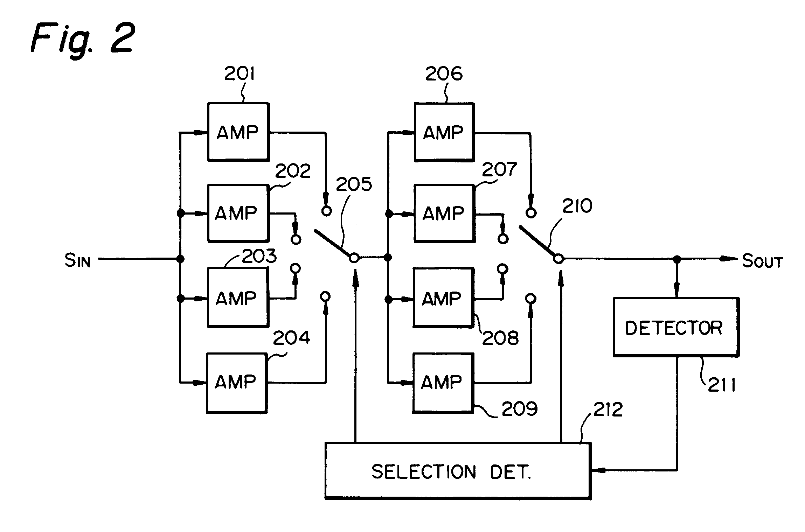

Before the description is made of the embodiments illustrative of the invention, previously proposed variable output amplifier apparatus will be described with reference to Figs. 1 and 2.

In Fig. 1, which illustrates a first previously proposed variable output amplifier apparatus for power transmission (see: JP-A-58-83437), an input signal S_{IN} is amplified by power amplifiers 101 and 102. A part of an output signal of the power amplifiers 102 is fed back by a directional coupler 103 to a detector 104. The directional coupler 103 also feeds an output signal S_{OUT}. A control circuit 105 compares a transmission power level detected by the detector 104 with a reference voltage V_{REF}, and as a result, a power supply V_{CC,}' of the power amplifier 102 is controlled in accordance with the comparison result of the transmission power level with the reference voltage V_{REF.} In addition, when the transmission power is low, a changeover switch 106 is selected at an upper position, so that the power supply of the power amplifier 102 is switched from V_{CC} to V_{CC}'.

In Fig. 1, however, when the changeover switch 106 is switched, a large noise spike is generated in the transient state. Also, since the gains of the power amplifiers 101 and 102 are controlled by their power supply, the input/output impedance conditions of the power amplifiers 101 and 102 are changed. Generally, when there is large change in the power supply, it is very difficult to maintain the characteristics of the power amplifier. Further, the operation of the detector 104 is a wide range from approximately 80 dB to 100 dB is very difficult.

In Fig. 2, which illustrates a second previously proposed variable output amplifier apparatus (see: JP-A-60-212013), four amplifiers 201 through 204 are connected in parallel for receiving an input signal S_{IN}. The amplifiers 201 through 204 are connected via a changeover switch 205 to four amplifiers 206 through 209 connected in parallel, the outputs of the amplifiers 206 to 209 being connected via a changeover switch 210 to a detector 211. The changeover switch 210 provides an output signal S_{OUT.} On the other hand, the output signal of the detector 211 is supplied to a selection determination circuit 212 for controlling the changeover switches 205 and 210. That is, the selection determination circuit 212 selects an optimum combination of one of the amplifiers 201 through 204 and one of the amplifiers 206 through 209, in accordance with the output of the detector 211.

Fig. 2, however, when the changeover switches 205 and 210 are switched to control the gain, a large noise spike is generated in the transient state. Also, changing a signal path causes a change in the delay time, and thus, an interruption may occur in a continuous signal.

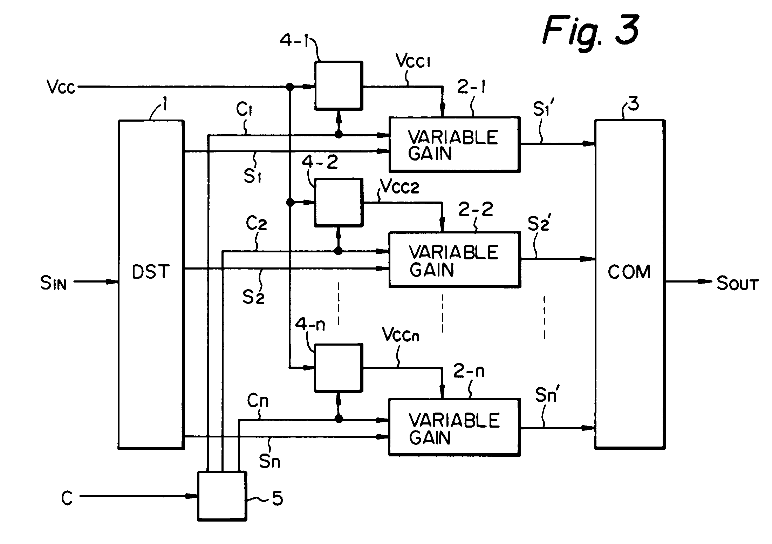

In Fig. 3 , which shows a first embodiment illustrative of the present invention, a distributing unit 1 distributes an input signal S_{IN} as signals S₁, S₂, .... Sₙ to variable gain units 2-1, 2-2, ..., 2-n, respectively. Output signals S₁', S₂', ..., Sₙ' of the variable gain units 2-1, 2-2, ..., 2-n are combined by a combining unit 3 to generate an output signal S_{OUT}.

Power supply voltages V_{CC1}, V_{CC2}, ..., V_{CCn} are applied to the variable gain units 2-1, 2-2, ..., 2-n from power supply control units 4-1, 4-2, ..., 4-n, respectively, which commonly receive a power supply V_{CC}.

The variable gain units 2-1, 2-2, ..., 2-n and the power supply control units 4-1, 4-2, ..., 4-n are controlled by control signals C₁, C₂, ..., Cₙ, respectively, of a control unit 5 which receives a gain control signal C. For example, when the control signal C₁ rises from low to high, the power supply control unit 4-1 promptly raises the power supply V_{CC1} from GND to V_{CC}, and then, the gain of the variable gain unit 2-1 gradually starts to change from the minimum value to the maximum value. On the other hand, when the control signal C₁ falls from high to low, the gain of the variable gain unit 2-1 starts gradually to change from the minimum value to the maximum value, and then the power supply control unit 4-1 switches the power supply V_{CC1} from V_{CC} to GND.

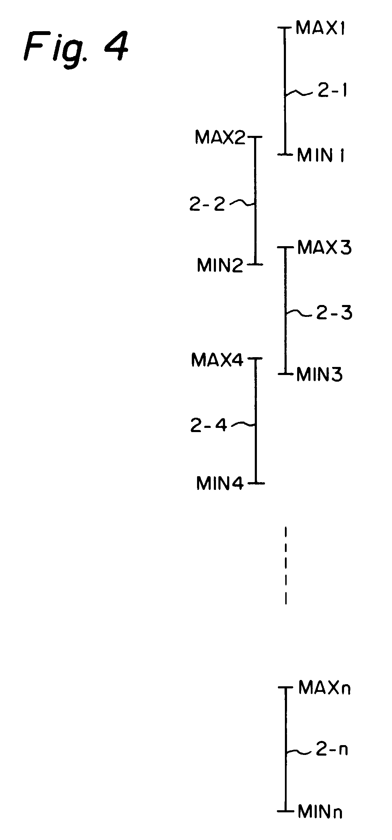

Examples of the gains of the variable gain units 2-1, 2-2,..., 2-n are as shown in Fig. 4. That is, the gain of the variable gain unit 2-1 ranges from MAX1 to MIN1; the gain of the variable gain unit 2-2 ranges from MAX2 to MIN2: ...; and the gain of the variable gain unit 2-n ranges from MAXn to MINn. In this case, the value MIN1 is smaller than the value MAX2, the value MIN2 is smaller than value MAX3, and so on.

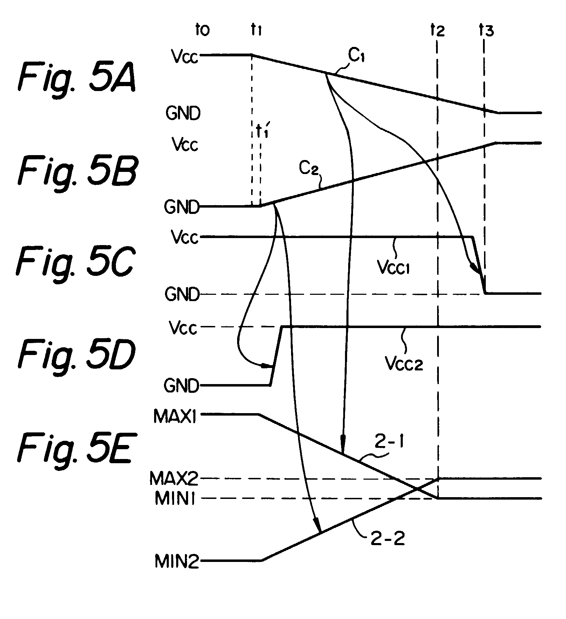

An example of the operation of the variable amplifier apparatus of Fig. 3 is explained next with reference to Figs. 5A through 5E.

First, at time tₒ, the control signals C₁ and C₂ are V_{CC} and GND, respectively, as shown in Figs. 5A and 5B, and accordingly, the power supplies V_{CC1} and V_{CC2} are V_{CC} and GND, respectively, as shown in Figs. 5C and 5D. Also, the gain of,the variable gain unit 2-1 is MAX1, and the gain of the variable gain unit 2-2 is MIN2, as shown in Fig. 5E.

Next, at time t₁, the control signal C₁ starts to fall from V_{CC} to GND, and almost simultaneously, at time t₁, the control signal C₂ starts to rise from GND to V_{CC}. As a result, the power supply V_{CC2} is switched by the power supply control unit 4-2 from GND to V_{CC}. Here, noise may be generated due to the rising of the power supply V_{CC2} in the variable gain unit 2-2. However, such noise can be neglected since the gain of the variable gain unit 2-2 is still MIN2. Also, as shown in Fig. 5E, the gain of the variable gain unit 2-1 gradually decreases, as a result of the falling of the control signal C₁, and the gain of the variable gain unit 2-2 gradually increases.

At time t₂, the gain of the variable gain unit 2-1 reaches MIN1, while the gain of the variable gain unit 2-2 reaches MAX2.

Finally, at time t₃, the power supply V_{CC1} is switched by the power supply control unit 4-1 from V_{CC} to GND. Here, noise may be generated due to the falling of the power supply V_{CC1} in the variable gain unit 2-1. However, such noise can be neglected since the gain of the variable gain unit 2-1 is already MIN1.

Note that a signal delay of each of the variable gain units 2-1, 2-2, ..., 2-n is equalized through the maximum gain control state to the minimum gain control state. Therefore, the output signal S_{OUT} of the combining unit 3 is smoothly switched from the maximum gain of the variable gain unit 2-1 to the maximum gain of the variable gain unit 2-2.

Generally, the larger the gain of the variable gain unit, the larger the power dissipation. Therefore, one of the variable gain units 2-1, 2-2, ..., 2-n, whose power dissipation is optimised at its maximum output power, and which can use the power supply effectively is selected.

Also, in the variable output amplifier apparatus of Fig. 3, if only one of the variable gain units 2-1, 2-2, 2-n is selected, the gain of the apparatus of Fig. 3 can be changed discretely from MAX1, MAX2 MAXn, as shown in Fig. 3. Therefore, if the number of the variable gain units 2-1, 2-2, ..., 2-n is increased, the gain of the apparatus of Fig. 3 can be almost continuously changed from MAX1 to MAXn.

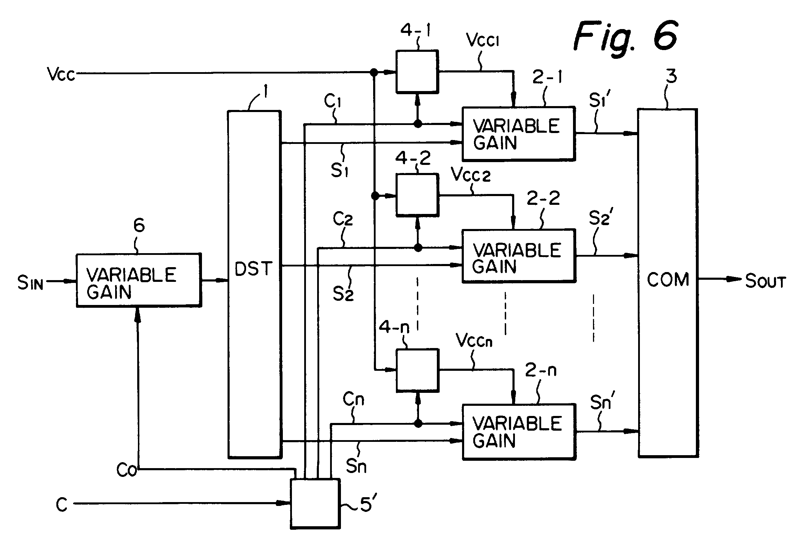

In Fig.6 which illustrates a second embodiment illustrative of the present invention, a variable gain unit 6 is added in a pre-stage to the elements of Fig. 3, thus obtaining a completely continuous change of the gain of the apparatus. The variable gain unit 6 is controlled by a control signal C₀ that is generated by a control unit 5'. In this case, the range of gain of the variable gain unit 5 is small, for example, form 0 to MAX, where MAX is larger than MAX2 in Fig. 4.

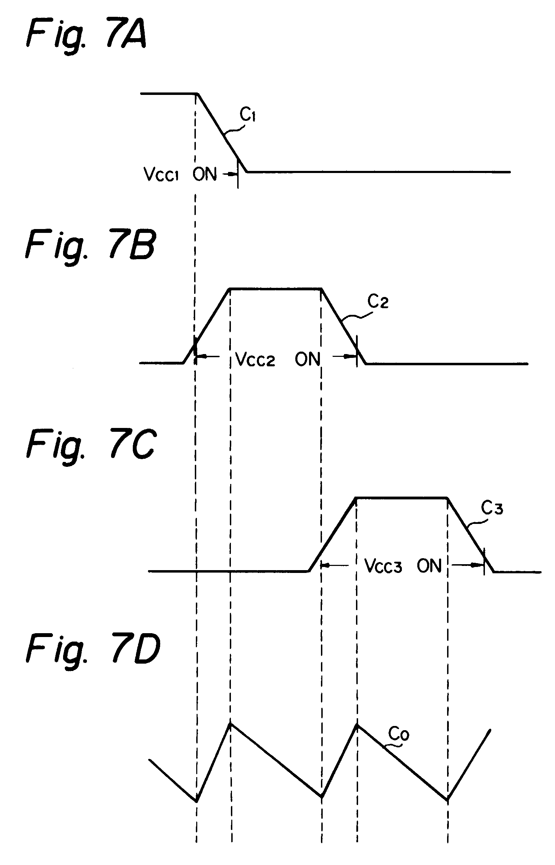

An example of the operation of the control unit 5' is explained with reference to Figs. 7A, 7B, 7C and 7D. Here, assume that the gain control signal C gradually decreases so that the variable gain units 2-1, 2-2, ..., 2-n are sequentially activated as shown in Figs. 7A, 7B and 7C. In this case, as shown in Fig. 7D, the level of the gain control signal C₀ for the variable gain unit 6 decreases gradually and stepwise as the gain control signal C gradually decreases. Therefore, the control unit 5' can be formed by a voltage divider, or the like, in addition to the elements of the control unit 5 of Fig. 3.

Each element of the apparatus of Fig. 3 and Fig. 6 will be explained next.

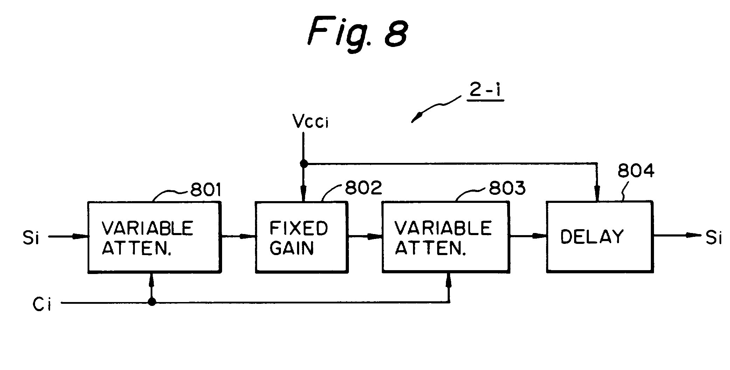

In Fig. 8, which is a detailed circuit diagram of the variable gain unit 2-i (i = 1, 2, ..., n) of Figs. 3 and 6, the signal Sᵢ passes through a variable attenuation unit 801, a fixed gain unit 802, a variable attenuation unit 803 and a delay unit 804. In this case, the variable attenuation units 801 and 803 are controlled by the control signal Cᵢ, while the fixed gain unit 802 and the delay unit 804 are activated by the power supply V_{CCi}. The maximum attenuations of the variable attenuation units 801 and 803 are larger than the maximum gain of the fixed gain unit 802. The delay time of the delay unit 804 compensates for the fluctuation of the variable attenuation units 801 and 803, so that the delay times of the variable gain units 2-1, 2-2, ..., 2-n are equalized.

Also, the attenuations of the variable attenuation units 801 and 803, defining the gain of the variable gain unit 2-i, are gradually changed in response to the change of the control signal Cᵢ. Thus, the gain of the variable gain unit 2-i is gradually changed, as shown in Fig. 5E.

Further, the fixed gain unit 802 is turned ON and OFF when the attenuations of the variable attenuation units 801 and 803 are maximum. Therefore, the input/output impedance of the fixed gain unit 802 fluctuates, and there is no adverse effect on the input signal Sᵢ and the output signal Sᵢ'.

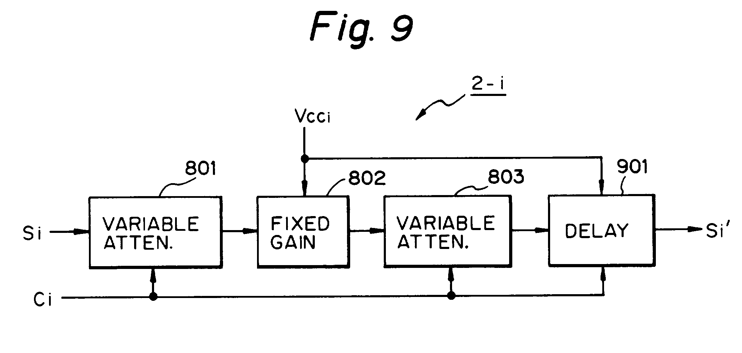

In Fig. 9, which is a modification of the variable gain unit 2-i of Fig. 8, a delay unit 901 is provided instead of the delay unit 804 of Fig. 8. That is, the delay unit 901 is also controlled by the control signal Cᵢ, so that the delay time of the entire variable gain unit 2-i is almost constant regardless of the change of the gain thereof.

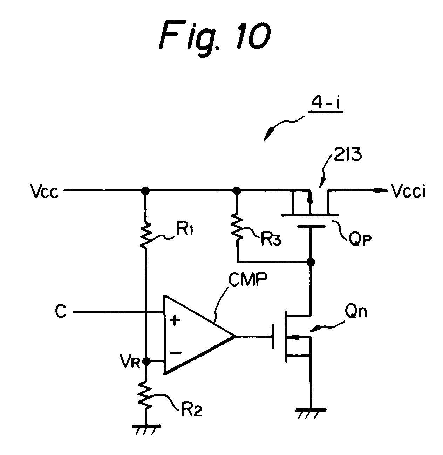

In Fig. 10, which is a detailed circuit diagram of the power supply control unit 4-i (i = 1, 2, ..., n) of Figs. 3 and 6, a comparator CMP compares the voltage of the signal C with a reference voltage V_{R} defined by resistors R₁ and R₂, so as to control an N-channel MOS transistor Qₙ. Also, a P-channel MOS transistor Qₚ is interposed between an input for the power supply V_{CC} and an output for the power supply V_{CCi}, and is controlled by the N-channel MOS transistor Qₙ. Further, a resistor R₃ is connected between the gate of the P-channel MOS transistor Qₚ and the input for the power supply V_{CC}.

When the voltage of the signal C becomes higher than V_{R}, the comparator CMP turns ON the N-channel MOS transistor Qₙ, so that the gate voltage of the P-channel MOS transistor Qₚ becomes low (=GND). As a result, the P-channel MOS transistor Qₚ is rapidly turned ON. Thus, the power supply v_{CCi} rapidly becomes V_{CC} (see Figs. 5B and 5D).

On the other hand, when the voltage of the signal Cᵢ becomes lower than V_{R}, the comparator CMP turns OFF the n-channel MOS transistor Qₙ. However, in this case, due to the presence of the resistor R₃, the gate voltage of the P-channel MOS transistor Qₚ becomes high (= V_{CC}). As a result, the P-channel MOS transistor Qₚ is turned OFF. Thus, the power supply v_{CCi} becomes GND (see Figs. 5A and 5C).

As has been explained, by employing the arrangements described above, illustrative of the present invention, a large amount of noise due to the switching of the power supply can be avoided. Also, the power supply can be used more effectively.

It will be understood, however, that although the invention has been illustrated by reference to particular embodiments, variations and modifications thereof, as well as other embodiments may be made within the scope of the protection sought by the appended claims.

## Claims

1. A variable output amplifier apparatus including
a distributing unit (1) for receiving an input signal (S_{IN}) to generate a plurality of first signals (S₁, S₂, ... Sₙ);
a plurality of variable gain units (2-1, 2-2, 2-n) connected to the distributing unit (1), each of the variable gain units (2-1, 2-2, ..., 2-n) receiving one of the first signals (S₁, S₂, ..., Sₙ);
a combining unit (3), connected to the variable gain units (2-1, 2-2, ..., 2-n), for combining second signals (S₁', S₂', ..., Sₙ') output from the variable gain units (2-1, 2-2, ..., 2-n) into an output signal (S_{OUT});
a plurality of power supply control units (4-1, 4-2, ..., 4-n), each connected to one of the variable gain units, for applying power supplies (V_{CC1,} V_{CC2}, ..., V_{CCn}) to the variable gain units; and
a control unit (5), connected to the variable gain units (2-1, 2-2, ..., 2-n) and the power supply control units (4-1, 4-2, ..., 4-n), for controlling the variable gain units (2-1, 2-2, ..., 2-n) and the power supply control units (4-1, 4-2, ..., 4-n),
a first one (2-1) of the variable gain units (2-1, 2-2, ..., 2-n) and a first one (4-1) of the power supply control units (4-1, 4-2, ..., 4-n) connected to the first one (2-1) of the variable gain units (2-1,2-2, 2-n) being activated by the control unit (5), so that the first one (4-1) of the power supply control units (4-1, 4-2, ..., 4-n) turns ON the power supply applied to the first one (2-1) of the variable gain units (2-1, 2-2, ..., 2-n), and
a second one (2-2) of the variable gain units (2-1, 2-2, ..., 2-n) and a second one (4-2) of the power supply control units (4-1, 4-2, ..., 4-n) connected to the first one (2-1) of the variable gain units (2-1, 2-2, 2-n) being deactivated by the control unit (5), so that the second one (4-2) of the power supply control units (4-1, 4-2, ..., 4-n) turns OFF the power supply applied to the second one (2-2) of the variable gain units (2-1, 2-2, ..., 2-n).

2. An apparatus as claimed in claim 1, wherein the control unit (5) deactivates one of the variable gain units (2-1, 2-2, ..., 2-n) and one of the power supply control units (4-1, 4-2, ..., 4-n) and simultaneously, activates another of the variable gain units (2-1, 2-2, 2-n) and another of the power supply control units (4-1, 4-2, ..., 4-n).

3. An apparatus as claimed in claim 1, wherein each of the variable gain units (2-1, 2-2, ..., 2-n) is activated by the control unit (5) to operate at a maximum gain state, each of the variable gain units (2-1, 2-2, ..., 2-n) being deactivated by the control unit (5) to operate at a minimum gain state.

4. An apparatus as claimed in claim 3, wherein the time of turning OFF the power supply applied to one of the variable gain units (2-1, 2-2, ..., 2-N) is greater than the time taken by one of the variable gain units (2-1, 2-2, ..., 2-n) to transit from a maximum gain state to a minimum gain state.

5. An apparatus as claimed in claim 1, including an additional variable gain unit (6) connected at a pre-stage of the distributing unit (1),
the gain of the additional variable gain unit (6) being continuously and stepwise controlled by a control unit (5').

6. An apparatus as claimed in claim 1, wherein each of the variable gain units (2-1, 2-2, ..., 2-n) includes
a first variable attenuation unit (801) for receiving one of the first signals, the first variable attenuation unit (801) being controlled by the control unit (5, 5');
a fixed gain unit (802) connected to the first variable attenuation unit (801), the fixed gain unit (802) being powered by one of the power supplies (V_{CCi});
a second variable attenuation unit (803) connected to the fixed gain unit (802); and
a delay unit (804, 901), connected to the second variable attenuation unit (803), for generating one of the second signals, the delay unit (804, 901) being powered by one of the power supplies (V_{CCi});
maximum attenuation of the first and second variable attenuation units (802) (803) being greater than the maximum gain of the fixed gain unit (802).

7. An apparatus as claimed in claim 6, wherein the delay unit (804, 901) is controlled by the control unit (5, 5'), so that the delay time of each of the variable gain units (2-1, 2-2, ..., 2-n) is approximately constant regardless of a change in the gain thereof.
